# EUROPEAN PATENT APPLICATION

(11) **EP 1 103 634 A1**
(43) Date of publication of application: **30.05.2001**
(21) Application number: 99870242.7
(22) Date of filing: 29.11.1999
(51) Int. Cl.: C23C 18/54

(54) **Method for contact plated copper deposition**

(71) Applicant: INTERUNIVERSITAIR MICRO-ELEKTRONICA CENTRUM VZW, 3001 Heverlee (BE)
(72) Inventor: Palmans, Roger, 3770 Riemst (BE); Lantasov, Yuri, 3001 Leuven (BE)
(74) Representative: Van Malderen, Joelle

(57) **Abstract**

The present invention describes a method for copper deposition on a substrate having a barrier layer wherein a substrate (2) and an activator (1) are immersed in a copper plating bath in order to contact each other for a predetermined period.

## Description

### Field of the invention

The present invention is related to metal deposition processes as used for instance for the formation of conductive patterns connecting active or passive devices as well as integrated circuits. In particular, such conductive patterns can be formed at least partly by means of an electroless deposition technique.

### Background of the invention

Electroless deposition has been used in the electronic packaging and the printed circuit board industry as a very efficient and cheap deposition technique for the production of thick films and for via-hole plating. To incorporate its use into the microelectronics industry, the reliability and quality of submicron lines and via's generated by electroless deposition is a key issue.

The electroless deposition method involves the formation of a thin film of material from a plating bath without external electric current. The deposition is due to an electrochemical reaction between the metal ions, a reducing agent, a complexing agent, and pH adjusters on a catalytic surface. The deposition occurs by simultaneous oxidation-reduction reactions between two half reactions involving electron generation and electron reduction. The metal cations in the solution accept electrons at the deposition surface, get reduced, and are deposited as metal. A catalytic surface usually consists of either: 1) a surface which has been activated for instance with palladium nuclei, 2) a thin evaporated or sputtered seed of a noble metal like gold, platinum or palladium, or 3) an insulator (or non-catalytic semiconductor or metal) which is sensitised by coating it with a thin metal that can be less than a mono-layer. Once a thin layer of metal has been deposited onto the seed layer or sensitised surface, electroless deposition continues autocatalytically, since the metallic film is also a good catalyst for electroless growth.

For trench or via-hole plating, European Patent Application Nr. 99 870 077.7 has proposed an original copper electroless plating bath fulfilling the stringent requirements for copper plating in sub-micro high aspect ratio features onto typical Cu diffusion barrier layer such as Ti, TiN, Ta, TaN, WxN, Ni and Ni-alloy and Co barrier-layers.

However, in order to obtain good quality electroless copper deposition on these barrier layers, first an activation step with deposition of palladium nuclei onto the barrier layer is required.

Moreover, the critical step for obtaining a catalytic surface to initiate copper deposition is still present.

### Aims of the invention

One aim of the present invention is to initiate copper deposition from a plating solution directly on said barrier layers without requiring the above mentioned palladium activation step.

Another aim of the invention is to provide a new method for a conform and high quality copper deposition on barrier layers.

### Summary of the invention

The invention discloses a new method for copper deposition on a substrate having a barrier layer characterized in that
- a substrate is immersed in a copper plating bath, and that
- an activator is also immersed in said copper bath and
- direct contact is performed between said activator and said substrate for a predetermined period.

The copper plating bath can be either a standard electroless plating bath or a plating bath without reducing agent.

The activator is preferably a contact metal which comprises at least an element selected from the group comprising Al, Zn, Mg, Pd.

The barrier layer is preferably selected from the group comprising a Ti layer, a TiN layer, a WxN layer, Ta, TaN, Ni and Ni-alloy barrier-layers or a Co layer.

The copper plating bath preferably comprises at least:
- a source of Cu (II) ions
- a complexing agent to keep the Cu(II) ions in solution at high pH values
- an additive to adjust the pH of said bath

This copper plating bath can also comprise a reducing agent, preferably formaldehyde or hypophosphite.

In the case of a copper electroless bath, the pH is comprised between 12.0 and 13.5. In the case of a plating solution without reducing agent, the pH process window is shifted up to the pH 12.5 to 13.5 range.

The predetermined time period for direct contact between the two samples is preferably comprised between 30 sec. and 10 min.

The activator may have a determined shape. It can be in the form of a clamping ring or metal contacts placed on the wafer edge in contact with the barrier layer.

The method according to the present invention is preferably used for electroless copper deposition on an opening (trench or via) in a substrate having a blanket barrier layer.

### Short description of the drawings

Figure 1 is describing a basic experiment involved in the first aspect of the present invention.

Figure 2 shows SEM pictures of Cu deposition on TiN by Al contact plating.

Figure 3 shows a device dedicated to an industrial process for electroless copper deposition, according to one preferred embodiment of the invention.

Figure 4 represents the several steps of a process for electroless copper deposition according to another preferred embodiment of the invention.

Figure 5 represents typical sheet resistance mappings over 6 inch wafers obtained with the copper deposition process according to the present invention.

Figures 6a and 6b represent TEM pictures of Cu deposition on TiN covered wafers using two different copper plating bathes.

### Description of several embodiments of the invention

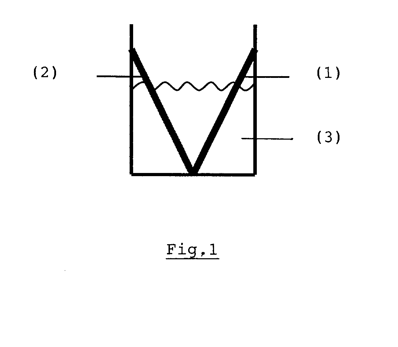

Figure 1 is describing a basic embodiment wherein a barrier layer on a substrate (2), hereafter referred to as sample 2, has been brought into contact with an Al-sample (1), hereafter referred to as sample 1 and is immersed either in a bath (3) being either a conventional electroless plating bath or a plating bath without a reducing agent. It is observed that Cu is deposited on the barrier layer if a contact occurs between the two samples. In the absence of contact between the two samples, no copper is deposited on the barrier layer. Also, it is observed that addition of Al(III) ions to the plating solution does not lead to copper deposition when no aluminium contact exists. Several other experiments have been performed based on the same experiment wherein :
(i) sample 1 is an Al-sample which can be:
   - Al alloy covered wafer: Pieces of wafer HLI (400 nm LLS Al-0.5%Cu on SiO2/Si)
   - or any aluminium substrate that can be brought into contact with the barrier layer (strips, foils, ...);
(ii) sample 2 is a wafer having on its top a barrier layer which can be:
   - TiN: Pieces of wafers TR9800923 (15 nm / 60 nm IMP Endura Ti/TiN on SiO2/Si). These samples are cleaned previously in 2,5% HF for 1 min (or in 5% HF for 30 sec)
   - WxN: Pieces of wafer TR9800482 #05 (60 nm WxN on SiO2/Si)
   - Co: Pieces of wafer TMPA #6 (60 nm Co on SiO2/Si)
   - TaN: Pieces of wafer CU9850 #6 (60 nm Endura TaN on SiO2/Si)
   - or Ta: Pieces of wafer TR9801029#24 (60 nm Endura Ta on SiO2/Si).

In a first embodiment of the present invention, the plating solution contains formaldehyde as reducing agent. The pH of solution has to be above 12.0.

It is observed that deposition occurs only in case that the barrier layer of sample 2 is TiN, WxN or Co. No deposition is observed in the case of TaN nor Ta.
The results are summarised in Table 1.

Based on the same experiment as described in figure 1, new experiments have been performed with the same solution but without formaldehyde and having a pH above 12.5 and wherein:
(i) sample 1 is:
   - Al foil with a thickness of 0.32 mm and a width of 30 mm
   - or an Al-covered wafer
(ii) the barrier layer on sample 2 is:
   - TiN: Pieces of wafers TR9801064 #23 and CU99119 #3,4 (ARC Encura Ti/TiN on SiO2/Si). Samples are cleaned previously in 2,5% HF for 1 min (or in 5% HF for 30 sec).
   - WxN: wafer TR9800482 #02 (60 nm WxN on SiO2/Si).
   - Co: Pieces of wafer TMPA #6, wafer TMPA #5 (60 nm Co on SiO2/Si).
   - TaN: Pieces of wafer CU9850 #6 (60 nm Endura TaN on SiO2/Si).
   - or Ta: Pieces of wafer TR9801029 #24 (60 nm Endura Ta on SiO2/Si).
The results are summarised in Table 2 for TiN samples only.

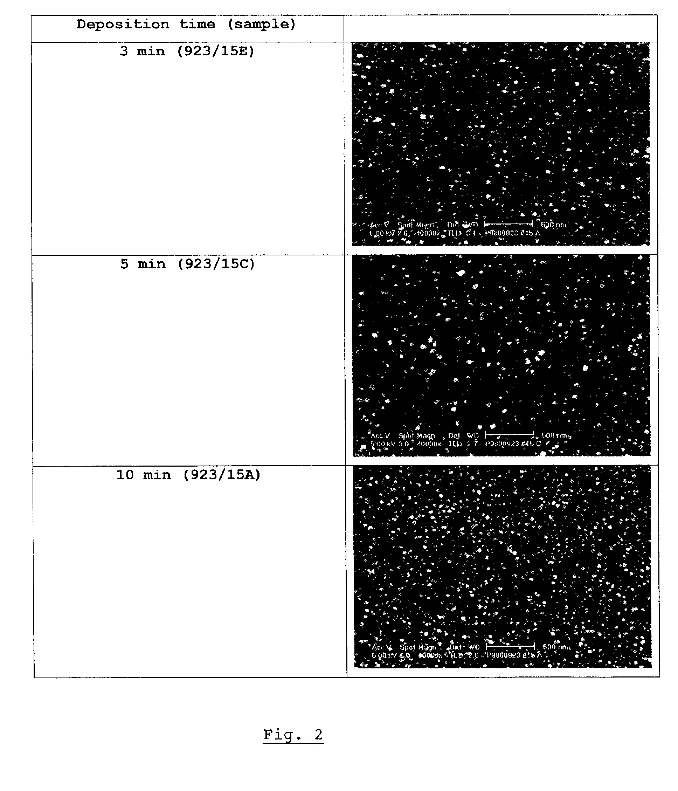

SEM pictures of Cu deposition on TiN by Al contact plating and corresponding to this experiment are presented on figure 2.

Other embodiments similar to those described in figure 1 have been undertaken with a conventional sodium hypophosphite electroless plating bath. In this case the pH is above 12.5. In these experiments, sample 1 is an Al sample, sample 2 has a TiN barrier layer.

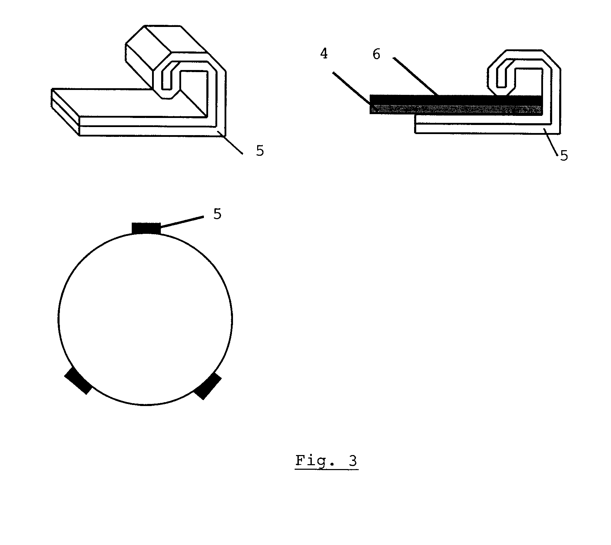

In order to have a best mode embodiment it is suggested to perform the Al-sample in the form of an Al-clamping holder which would clamp the wafer having the barrier layer. Figure 3 is showing such a device used in one preferred embodiment of the present invention that comprises a wafer (4) and 3 Al holders (5). The wafer (4) is typically a Si/SiO2 wafer having a TiN, a WxN, or a Co barrier (6). The Al holders (5) are made from Al foil and have the shape of clamping holders. In this experiment, each Al holder has a surface area of (130x30 + 20x130x0.32 + 2x30x0.32) mm².

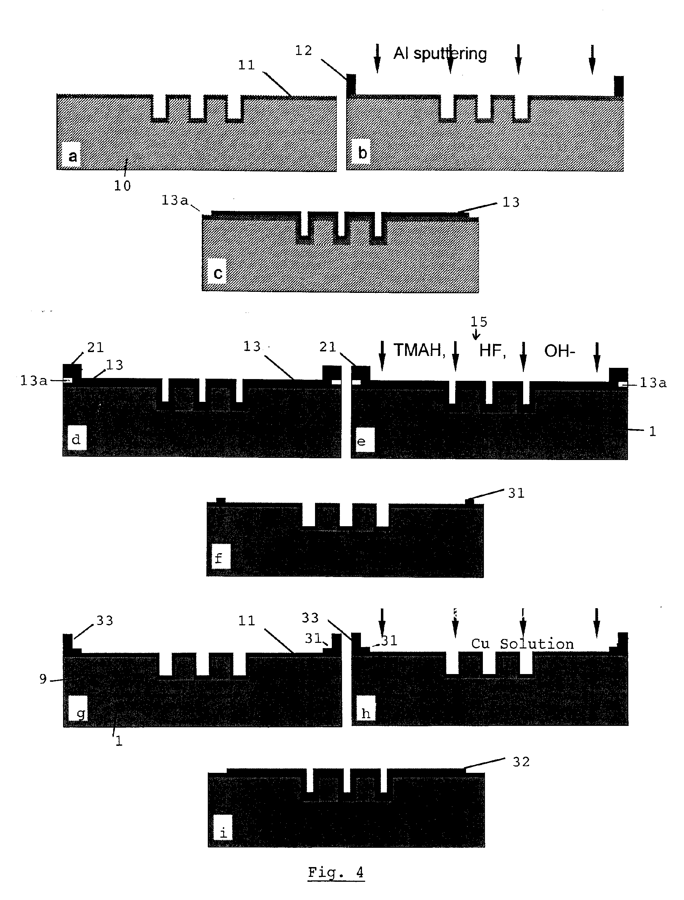

Another best mode of using the method according to the present invention is described in Figure 4, wherein the aluminium ring is formed directly on the barrier layer surface during processing. This best mode embodiment consists of the following steps:
(a) deposition of a barrier layer (11) typically Ti, TiN, Co, Ta, TaN, Ni, Ni alloy or WxN on a wafer (10),
(b) fixing a first clamping ring (12) on the top surface of said barrier layer and Al sputtering on said wafer,
(c) removing the clamping ring (12) from the wafer, so that an area (13a) on the barrier layer is not covered by the Al layer (13),
(d) fixation of a second clamping ring (21) covering the whole zone (13a) and partially the Al layer (13) on the top surface of the wafer (1),
(e) etching of Al in central part (15) of the wafer (1) in a plating tool by either hydroxide solution (NaOH, Tetramethylammonium hydroxide (TMAH), ...) or by an acidic solution such as HF solution,
(f) after the Al layer has disappeared, said second clamping ring (21) is removed from the wafer, so that only a small portion in the form of a ring of Al still remains directly in contact with the barrier layer (11) on the wafer (1).
(g) A third clamping ring (33) is fixed on one extremity of the wafer on the top surface so that the Al contact is exposed to the plating solution.
(h) Cu plating is initiated on the exposed barrier layer (11) due to dissolution of the Al ring (31).
(i) Finally the third clamping ring (33) is removed and a wafer (1) having a barrier layer (11) covered with a Cu layer (32) except on its extremities is obtained.

The Al sputtering in step (b) can also be done in a tool without a clamping ring on said wafer.

Experiments have been performed to check copper deposition on full wafers according to one preferred embodiment of the present invention (Table 3). In these experiments, sample 1 is an Al holder or an Al ring and sample 2 a Co, a WxN or a TiN covered wafer. The solution is a copper plating solution without formaldehyde and having a pH above 12.5.

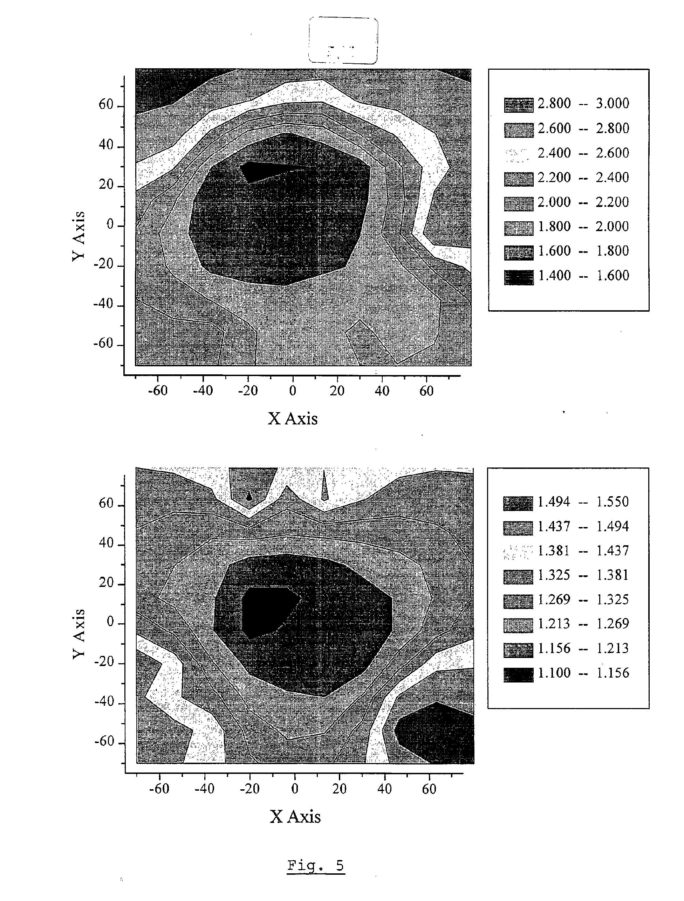

Sheet resistance mappings measured for these wafers are presented in figure 5.

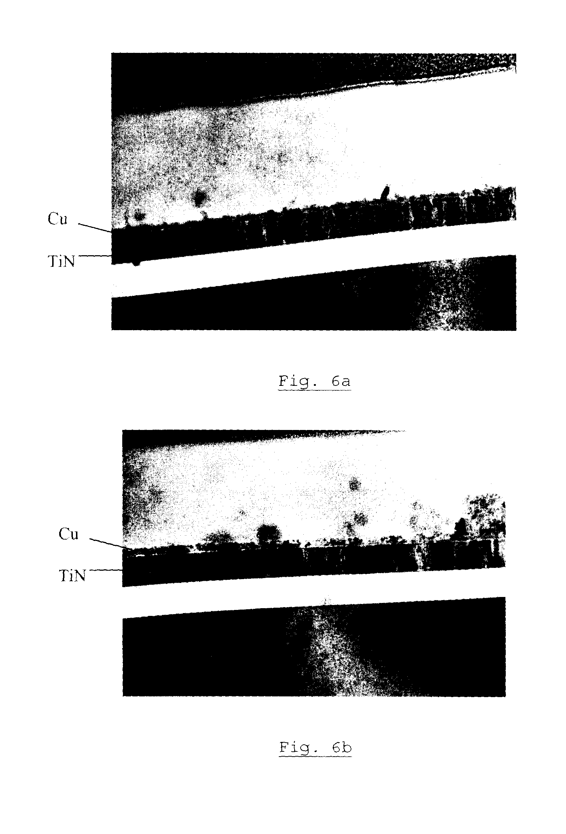

Moreover, two distinct experiments for copper deposition on TiN covered wafers according to another prefrred embodiment of the invention have been performed, both using the same copper deposition time, but the first one using a copper plating bath with formaldehyde at pH = 12.42, while the second using a copper plating bath without formaldehyde at pH = 13.0. These two experiments lead to copper covered wafers with different deposition rates: the copper covered wafer has a resistance of 1.97 Ω / sq. and a thickness of 24.4 nm in the first experiment and the copper covered wafer has a resistance of 3.815 Ω / sq. and a thickness of 18.7 nm. TEM pictures illustrating these results are presented in figure 6a and figure 6b, for the first and the second experiments respectively.

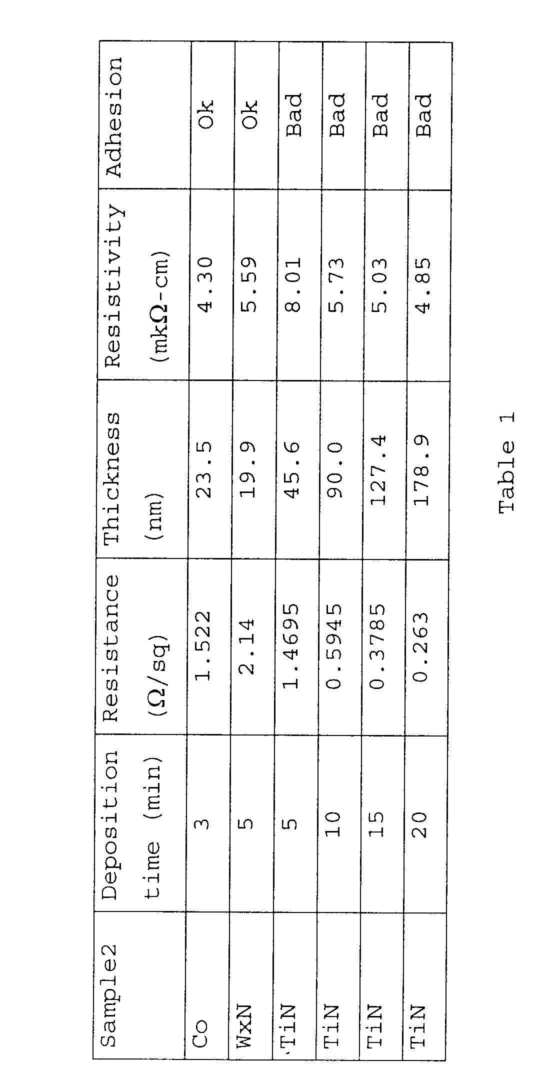

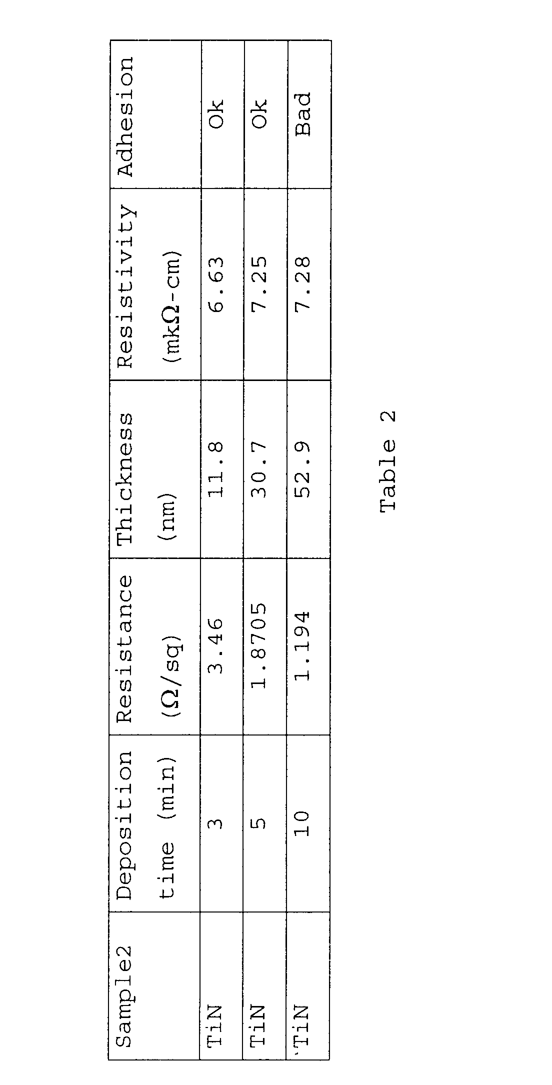

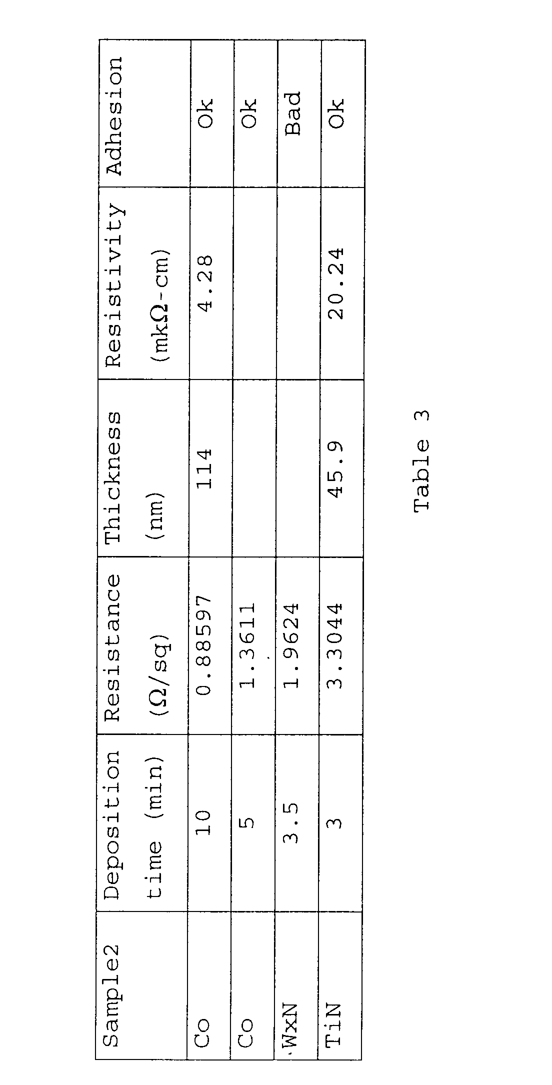

## Claims

1. A contact plating method for copper deposition on a substrate (2) having a barrier layer characterized in that - a substrate is immersed in a copper plating bath, and
- an activator (1) is also immersed in said copper plating bath and
- a direct contact is performed between said activator and said substrate for a predetermined period.

2. A method according to claim 1, characterized in that said activator is a contact metal which comprises at least an element selected from the group comprising Al, Zn, Mg, Pd.

3. A method according to claim 1, characterized in that said barrier layer is selected from the group comprising a Ti layer, a TiN layer, a WxN layer, Ta layer, TaN layer, Ni layer, Ni-alloy layer or a Co layer.

4. A method according to claim 1, characterized in that said copper plating bath comprises at least:
- a source of Cu (II) ions
- a complexing agent to keep Cu(II) ions in solution at high pH
- an additive to adjust the pH of said bath.

5. A method according to claim 4, characterized in that said copper plating bath is a copper bath without reducing agent.

6. A method according to claim 4, characterized in that said copper plating bath is a copper electroless bath.

7. A method according to claim 6, characterized in that said copper electroless bath comprises a reducing agent.

8. A method according to any one of the preceding claims 4 to 7, characterized in that said copper plating bath has a pH comprised between 12.0 and 13.5.

9. A method according to claim 1, characterized in that said predetermined time period for direct contact between said substrate (2) and said activator (1) is comprised between 10 sec. and 30 min.

10. A method according to claim 1 or 2, characterized in that the activator (1) has a determined shape.

11. A method according to claim 11, characterized in that said determined shape of said activator (1) is a clamping holder (5).

12. A method according to claim 11, characterized in that said determined shape of said activator (1) is a wafer-based contact metal device (31).

13. Use of the method according to any one of the preceding claims for copper deposition on an opening or a via in a substrate having a blanket barrier layer.

14. Solution used to perform the method according to any one of the preceding claims for copper deposition, characterized in that it contains at least:
- a source copper Cu (II) ions
- a complexing agent to keep Cu(II) ions in solution at high pH
- an additive to adjust the pH of said bath between 12.0 and 13.5
- ions of at least an element selected from the group comprising Al, Zn, Mg, Pd.

15. A device for copper deposition, characterized in that it contains means for performing the method according to any of the preceding claims 1-14 can be performed.
